# EUROPÄISCHE PATENTSCHRIFT

(11) **EP 0 803 148 B1**
(45) Veröffentlichungstag und Bekanntmachung des Hinweises auf die Patenterteilung: **22.10.2003**
(21) Anmeldenummer: 95941590.2
(22) Anmeldetag: 15.12.1995
(51) Int. Cl.: H03K 3/356, H03K 17/10

(54) **VERFAHREN ZUM SCHALTEN VON HÖHEREN SPANNUNGEN AUF EINEM HALBLEITERCHIP**
METHOD FOR SWITCHING HIGH VOLTAGES ON A SEMICONDUCTOR CHIP
PROCEDE POUR LA COMMUTATION DE TENSIONS ELEVEES SUR UNE PUCE A SEMI-CONDUCTEURS

(30) Priorität: 09.01.1995 DE 19500393
(43) Veröffentlichungstag der Anmeldung: 29.10.1997
(73) Patentinhaber: Infineon Technologies AG, 81669 München (DE)
(72) Erfinder: WINNERL, Josef, D-81929 München (DE)
(74) Vertreter: Epping Hermann & Fischer
(86) Internationale Anmeldenummer: DE9501804
(87) Internationale Veröffentlichungsnummer: WO96021971

(56) Entgegenhaltungen:
- EP-A- 0 082 208
- US-A- 4 649 521
- US-A- 4 656 373
- US-A- 5 266 848
- IEEE International Solid State Circuits IEEE International Solid State Circuits Conference 1991, Digest of Technical Conference 1991, Digest of Technical Papers, Seiten 260, 261 and 326, "A 60ns Papers, Seiten 260, 261 and 326, "A 60ns 16Mb Flash EEPROM with Program and Erase 16Mb Flash EEPROM with Program and Erase Sequence Controller" Sequence Controller"

## Beschreibung

Verfahren zum Schalten höherer Spannungen auf einem Halbleiterchip.

Die Erfindung betrifft ein Verfahren zum Schalten von höheren Spannungen auf einem Halbleiterchip mit einer ersten Serienschaltung aus einem ersten p-Kanal- und einem ersten n-Kanal-Transistor, die zwischen einen Anschluß für ein erstes hohes und einen Anschluß für ein erstes niederes Potential geschaltet ist, mit einer zweiten Serienschaltung aus einem zweiten p-Kanal- und einem zweiten n-Kanal-Transistor, die zwischen den Anschluß für das erste hohe Potential und einen ersten Eingangsanschluß geschaltet ist, wobei der Verbindungspunkt der beiden Transistoren der ersten Serienschaltung mit dem Gate-Anschluß des zweiten p-Kanal-Transistors verbunden ist und einen Anschluß für ein Ausgangssignal bildet, wobei der Verbindungspunkt der Transistoren der zweiten Serienschaltung mit dem Gateanschluß des ersten p-Kanal-Transistors verbunden ist und wobei der Gate-Anschluß des zweiten n-Kanal-Transistors einen zweiten Eingangsanschluß bildet.

Eine solche Schaltungsanordnung ist aus der Schrift Proceedings ISSCC 1991, Seite 260 bekannt. Hierbei ist der Gateanschluß des ersten n-Kanal-Transistors mit dem Gateanschluß des ersten p-Kanal-Transistors verbunden. Außerdem ist das erste niedere Potential gleich dem Massepotential.

Aus der US 5 266 848 ist eine Signaltreiberschaltung bekannt, die eine erste Reihenschaltung aus p- und u- Kanal Transistoren aufweist, die zwischen den Betriebsspannungs potentialen angeschlossen sind. Der Verbindungspunkt zwischen den Transistoren stellt den Ausgangsanschluß dar. Weiterhin ist eine zweite Reihenschaltung und eine dritte Reihenschaltung, jeweils aus p- und n-Kanal Transistoren bestehend, zwischen den Betriebs potentialen angeschlossen, wobei die zweite Reihenschaltung mit der dritten Reihenschaltung wieder um eine Reihenschaltung bildet. Der Eingangsanschluß dieser Schaltungsanordnung ist durch den Verbindungspunkt von zweiter und dritter Reihenschaltung gegeben.

Bei auf Halbleiterchips integrierten Schaltungen ist es oftmals nötig, außer den üblichen Betriebsspannungen von beispielsweise +5V und 0V bei TTL und CMOS weitere Spannungen, die deutlich höher oder auch negativ sein können, zuzuführen oder auf dem Chip aus den Betriebsspannungen zu erzeugen und gegebenenfalls ein- und auszuschalten. Wenn solche Halbleiterchips nicht-flüchtige Speicher wie beispielsweise EPROMs, EEPROMs oder Flash-Speicher enthalten, werden dafür Programmierspannungen benötigt, die Werte im Bereich von 12V bis 20V aufweisen müssen oder je nach Speicherkonzept, auch negativ sein können. Die aus dem erstgenannten Dokument bekannte Schaltungsanordnung dient dem Schalten einer höheren Programmierspannung. Mit dieser bekannten Schaltungsanordnung lassen sich jedoch keine negativen Spannungen schalten.

Aufgabe der Erfindung ist es, ein Verfahren zum Schalten höherer Spannungen auf einem Halbleiterchip anzugeben, bei dem sowohl positive als auch negative Spannungen geschaltet werden können und die dabei querstromfrei sind.

Die Aufgabe wird durch die Merkmale des Anspruchs 1 gelöst. Vorteilhafte Weiterbildungen der Erfindung sind in den abhängigen Ansprüchen ausgeführt.

Eine Schaltungsanordnung kann auf einfache Weise ohne zusätzlichen Schaltungsaufwand als nicht-invertierender oder als invertierender Schalter verwendet werden. Die Funktion ist nur abhängig von den Spannungen, die an die vier Eingangsanschlüsse angelegt werden und davon, wie diese zusammengeschaltet sind. Besonders vorteilhaft ist es, wenn die zu schaltende Spannung beim Einschalten einen rampenförmigen Verlauf aufweist. Um eine Substratvorspannung im Logikteil des Halbleiterchips zu vermeiden, ist es vorteilhaft, bei einem n-Substrat die mit dem ersten hohen Potential verbundenen p-Kanal-Transistoren und bei einem p-Substrat die mit dem ersten neideren Potential verbundenen n-Kanal-Transistoren in einer Wanne des gleichen Leitungstyps wie das Substrat, die vom Substrat durch ein Gebiet des anderen Leitungstyps isoliert ist, auszubilden.

Die Erfindung soll nachfolgend anhand von Ausführungsbeispielen mit Hilfe von Figuren näher erläutert werden. Dabei zeigen:
- Figur 1: eine allgemeine Darstellung einer Schaltungsanordnung mit Tri-State-Möglichkeit,
- Figur 2: die Darstellung eines nicht-invertierenden Schalters
- Figur 3: die Darstellung eines invertierenden Schalters und
- Figur 4: Möglichkeiten zur technologischen Realisierung.

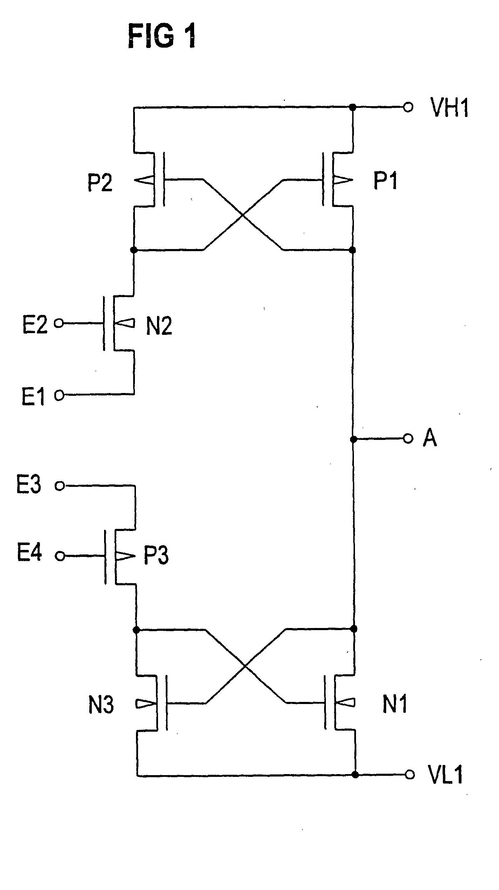

Bei dem erfindungsgemäße verfahren in der Figur 1 ist zwischen den Anschluß für ein erstes hohes Potential VH1 und den Anschluß für ein erstes niederes Potential VL1 die Serienschaltung aus einem ersten p-Kanal-Transistor P1 und einen ersten n-Kanal-Transistor N1 geschaltet. Der Verbindungspunkt der beiden Transistoren bildet einen Ausgangsanschluß A. Zwischen den Anschluß für das erste hohe Potential VH1 und den Gateanschluß des ersten p-Kanal-Transistors P1 ist die Laststrecke eines zweiten p-Kanal-Transistors P2 geschaltet. Der Gateanschluß dieses zweiten p-Kanal-Transistors P2 ist mit dem Ausgangsanschluß A verbunden. Der Gateanschluß des ersten p-Kanal-Transistors P1 ist außerdem über die Laststrecke eines zweiten n-Kanal-Transistors N2 mit einem ersten Eingangsanschluß E1 verbunden. Der Gateanschluß dieses zweiten n-Kanal-Transistors N2 ist mit einem zweiten Eingangsanschluß E2 verbunden. Zwischen dem Gateanschluß des ersten n-Kanal-Transistors N1 und dem Anschluß für das erste niedere Potential VL1 ist die Laststrecke eines dritten n-Kanal-Transistors N3 geschaltet. Der Gateanschluß dieses dritten n-Kanal-Transistors N3 ist ebenfalls mit dem Ausgangsanschluß A verbunden, während der Gateanschluß des ersten n-Kanal-Transistors N1 über die Laststrecke eines dritten p-Kanal-Transistors P3 mit einem dritten Eingangsanschluß E3 verbunden ist. Der Gateanschluß des dritten p-Kanal-Transistors P3 ist mit einem vierten Eingangsanschluß E4 verbunden. Mit dieser Schaltungsanordnung kann durch geeignete Wahl der Potentiale an den Eingangsanschlüssen E1 bis E4 entweder das erste hohe Potential VH1 oder das erste niedere Potential VL1 zum Ausgangsanschluß A durchgeschaltet werden, oder es kann der Ausgangsanschluß A hochohmig geschaltet werden. Ein besonderer Vorteil dieser Schaltungsanordnung ist, daß das erste niedere Potential VL1 negative Werte annehmen kann.

Um das erste hohe Potential VH1 zum Ausgangsanschluß A durchzuschalten, muß an den zweiten Eingangsanschluß E2 ein höheres Potential als an den ersten Eingangsanschluß E1 angelegt werden. Dabei muß außerdem das Potential am ersten Eingangsanschluß E1 niedriger sein als das erste hohe Potential VH1. Dadurch wird der zweite n-Kanal-Transistor N2 leitend geschaltet, wodurch auch der erste p-Kanal-Transistor P1 leitend geschaltet wird. Der Ausgangsanschluß A nimmt somit den Wert des ersten hohen Potentials VH1 an und schaltet damit auch den zweiten p-Kanal-Transistor P2 leitend, wodurch der erste p-Kanal-Transistor in seiner leitenden Stellung verriegelt wird.Wenn gleichzeitig das Potential am vierten Eingangsanschluß E4 größer oder gleich dem Potential am dritten Eingangsanschluß E3 ist, sperrt der dritte p-Kanal-Transistor P3, während der dritte n-Kanal-Transistor N3 aufgrund des hohen Potentials am Ausgangsanschluß A und damit an seinem Gateanschluß leitet und den Gateanschluß des ersten n-Kanal-Transistor N1 zum ersten niederen Potential VL1 zieht, wodurch der erste n-Kanal-Transistor N1 sicher sperrt und durch den dritten n-Kanal-Transistor N3 in dieser Stellung verriegelt wird.

Wenn das Potential am vierten Eingangsanschluß E4 kleiner als das Potential am dritten Eingangsanschluß E3 und das Potential am zweiten Eingangsanschluß E2 kleiner als das Potential am ersten Eingangsanschluß E1 gewählt wird, wird in äquivalenter Weise das erste niedere Potential VL1 zum Ausgangsanschluß A durchgeschaltet.

Die Schaltungsanordnung wird besonders vorteilhaft betrieben, wenn das zum Ausgangsanschluß A durchzuschaltende Potential erst nach dem Anlegen der Potentiale an die Eingangsanschlüsse E1 bis E4 eingeschaltet wird und/oder einen rampenförmigen Verlauf hat, d. h. also nicht plötzlich eingeschaltet, sondern langsam auf seinen Endwert hochgefahren wird. Hierdurch ist ein besonders sicherer Betrieb möglich.

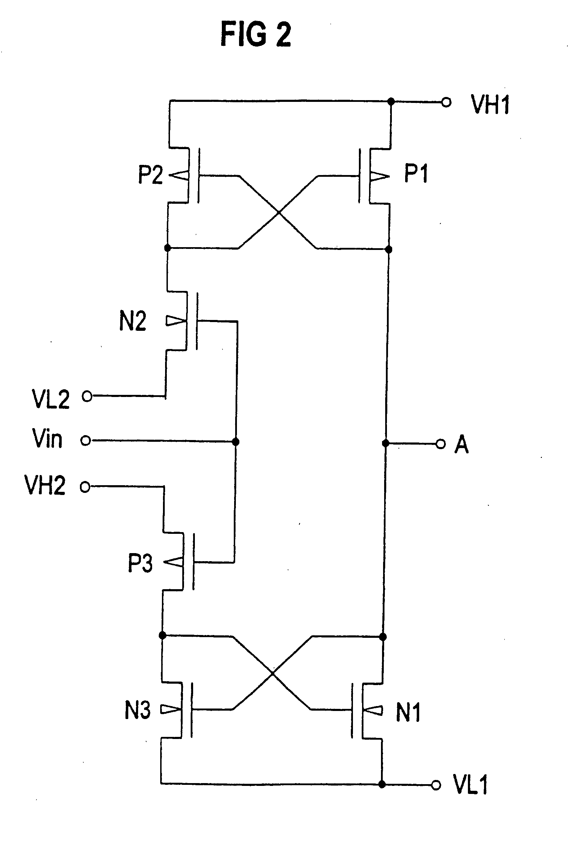

Eine spezielle Variante der Schaltungsanordnung nach Figur 1 ist in Figur 2 dargestellt. Hier sind die Eingangsanschlüsse E2 und E4 zusammengeschaltet und mit einem Steuersignal Vin beaufschlagt. Am ersten Eingangsanschluß E1 liegt ein zweites niederes Potential VL2, das größer oder gleich dem ersten niederen Potential VL1 ist, während am vierten Eingangsanschluß ein zweites hohes Potential VH2 anliegt, das kleiner oder gleich dem ersten hohen Potential VH1 ist. Diese Variante stellt einen bezüglich des Steuersignals Vin nicht-invertierenden Schalter dar, da bei einem Pegel dieses Steuersignals Vin der gleich dem zweiten hohen Potential VH2 ist, der Ausgangsanschluß A den Wert des ersten hohen Potentials VH1 annimmt und umgekehrt.

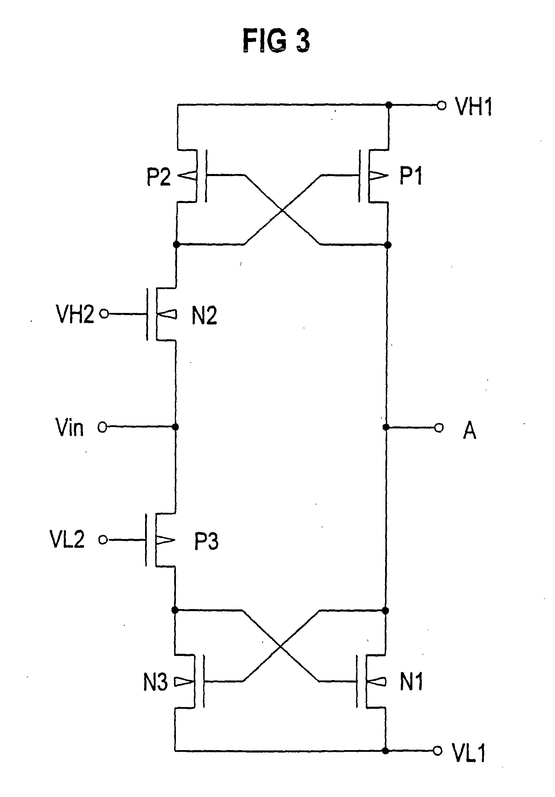

Im Gegensatz dazu zeigt die Figur 3 einen bezüglich eines Steuersignals Vin invertierenden Schalter. Hierzu sind der erste und der dritte Eingangsanschluß E1, E3 zusammengeschaltet und mit dem Steuersignal Vin beaufschlagt, während am zweiten Eingangsanschluß E2 ein zweites hohes Potential VH2 und am vierten Eingangsanschluß E4 ein zweites niederes Potential VL2 angelegt ist. Für die Werte der zweiten Potentiale gelten die selben Bedingungen wie bei der Schaltung gemäß Figur 2.

Die beschriebenen Schaltungsanordnungen sind zwar allgemein anwendbar, eignen sich aber in besonders vorteilhafter Weise für die Ansteuerung der Wortleitung in Flash-Speichern. Dort sind das zweite hohe Potential VH2 die Versorgungsspannung des Chips und das zweite niedere Potential VL2 das Bezugspotential. Das erste hohe Potential VH1 ist die Löschspannung und das erste niedere Potential VL1 die Programmierspannung. Außerdem muß eine zweite positive Spannung als Lesespannung auf die Wortleitung geschaltet werden können. Dies geschieht, indem statt der Löschspannung diese Lesespannung als erstes hohes Potential gewählt wird. Abhängig von der gewählten Variante der Schaltungsanordnung als invertierender oder nicht-invertierender Schalter kann somit durch geeignete Wahl des Steuersignals Vin jeweils die gewünschte Spannung auf die Wortleitung geschaltet werden.

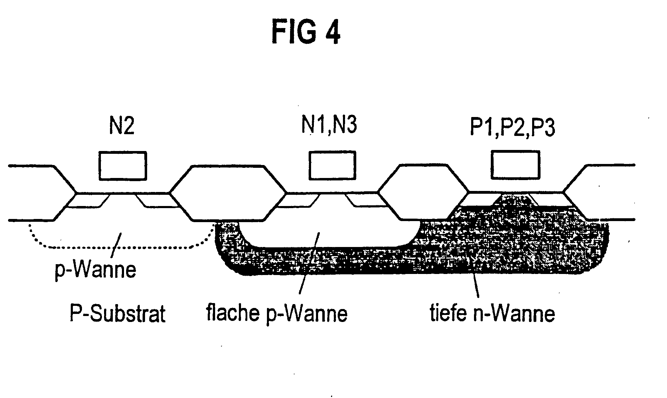

Die technologische Realisierung der Schaltungsanordnungen ist mit Standard-CMOS möglich. Bei n- bzw. p-Wannen-Technologie ist dabei zu beachten, daß das Substratpotential auf der niedrigsten (negativsten) beziehungsweise höchsten (positivsten) Spannung liegen muß. Für die Fälle, daß das erste niedere Potential kleiner als das zweite niedere Potential ist und eine n-Wanne vorgesehen ist beziehungsweise daß das erste hohe Potential größer als das zweite hohe Potential ist and eine p-Wanne vorgesehen ist, bedeutet dies, daß die n-Kanal- bzw. p-Kanal-Transistoren im Logikteil des Halbleiterchips (der mit dem ersten und dem zweiten niederen Potential versorgt ist) mit einer Substratvorspannung beaufschlagt sind. Mit der sogenannten "Triple-Well"-Technik läßt sich diese Substratvorspannung im Logikteil vermeiden. Bei einem p-Substrat, wie es in Figur 4 dargestellt ist, werden der erste und der dritte n-Kanal-Transistor in der isolierten p-Wanne realisiert, so daß das Substratpotential für die Logiktransistoren auf dem zweiten niederen Potential, also üblicherweise auf Massepotential, liegen kann. Bei einem n-Substrat müßten entsprechen der erste und der zweite p-Kanal-Transistor in einer isolierten n-Wanne liegen.

## Patentansprüche

1. Verfahren zum Schalten von höheren Spannungen auf einem Halbleiterchip mittels einer auf diesem realisierten Schaltungsanordnung, die gebildet ist
- mit einer ersten Serienschaltung aus einem ersten p-Kanal-(P1) und einem ersten n-Kanal-Transistor (N1), die zwischen einen ersten Schaltanschluß (VH1) und einen zweiten Schaltanschluß (VL1) geschaltet ist,
- mit einer zweiten Serienschaltung aus einem zweiten p-Kanal- (P2) und einem zweiten n-Kanal-Transistor (N2), die zwischen den ersten Schaltanschluß (VH1) und einen ersten Eingangsanschluß (E1) geschaltet ist,
- wobei der Verbindungspunkt der beiden Transistoren (P1, N1) der ersten Serienschaltung mit dem Gate-Anschluß des zweiten p-Kanal-Transistors (P2) verbunden ist und einen Ausgangsanschluß (A) bildet,
- wobei der Verbindungspunkt der Transistoren (P2, N2) der zweiten Serienschaltung mit dem Gateanschluß des ersten p-Kanal-Transistors (P1) verbunden ist und
- wobei der Gate-Anschluß des zweiten n-Kanal-Transistors (N2) einen zweiten Eingangsanschluß (E2) bildet,
- mit einer dritten Serienschaltung aus einem dritten p-Kanal- (P3) und einem dritten n-Kanal-Transistor (N3), die zwischen einen dritten Eingangsanschluß (E3) und den zweiten Schaltanschluß (VL1) geschaltet ist,
- wobei der Verbindungspunkt der beiden Transistoren (P1, N1) der ersten Serienschaltung mit dem Gate-Anschluß des dritten n-Kanal-Transistors (N3) verbunden ist,
- wobei der Verbindungspunkt der Transistoren (P3, N3) der dritten Serienschaltung mit dem Gateanschluß des ersten n-Kanal-Transistors (N1) verbunden ist und
- wobei der Gate-Anschluß des dritten p-Kanal-Transistors (P3) einen vierten Eingangsanschluß (E4) bildet, wobei
- zuerst an die Eingangsanschlüsse (E1, E2, E3, E4) Potentiale angelegt werden, und
- erst nach dem Anlegen der Potentiale an die Eingangsanschlüsse (E1, E2, E3, E4) an den ersten Schaltanschluß (VH1) ein Potential, das größer als die Potentiale an den Eingangsanschlüssen ist oder an den zweiten Schaltanschluß (VL1) ein Potential, das kleiner als die Potentiale an den Eingangsanschlüssen ist, angelegt wird.

2. Verfahren nach Anspruch 1, wobei
die Potentiale an den Schaltanschlüssen (VH1, VL1) nach dem Einschalten langsam auf ihren Endwert hochgefahren werden.

3. Verfahren nach einem der Ansprüche 1 oder 2, wobei ,
der zweite und der vierte Eingangsanschluß (E2, E4) der Schaltungsanordnung miteinander verbunden sind und einen Anschluß für ein Steuersignal (Vin) bilden,
der erste Eingangsanschluß (E1) ein Anschluß für ein zweites niederes Potential (VL2) ist, das gleich der niederen Betriebsspannung ist und
der dritte Eingangsanschluß (E3) ein Anschluß für ein zweites hohes Potential (VH2) ist, das gleich der hohen Betriebsspannung ist.

4. Verfahren nach einem der Ansprüche 1 oder 2, wobei
der erste und der dritte Eingangsanschluß (E1, E3) der Schaltungsanordnung miteinander verbunden sind und einen Anschluß für ein Steuersignal (Vin) bilden,
der zweite Eingangsanschluß (E2) ein Anschluß für ein zweites hohes Potential (VH2) ist, das gleich der hohen Betriebsspannung ist und
der vierte Eingangsanschluß (E4) ein Anschluß für ein zweites niederes Potential (VL2) ist, das gleich der niederen Betriebsspannung ist.

5. Verfahren nach einem der Ansprüche 1 bis 4, wobei
bei technologischer Realisierung der Transistoren in einem p-leitenden Substrat der erste und der dritte n-Kanal-Transistor (N1, N3) in einer vom p-Substrat isolierten p-Wanne ausgebildet sind.

6. Verfahren nach einem der Ansprüche 1 bis 5, wobei
bei technologischer Realisierung der Transistoren in einem n-leitenden Substrat der erste und der zweite p-Kanal-Transistor (P1, P2) in einer vom n-Substrat isolierten n-Wanne ausgebildet sind.

## Claims

1. Method for switching relatively high voltages on a semiconductor chip by means of a circuit arrangement realized thereon and formed,
- with a first series circuit which is formed by a first p-channel transistor (P1) and a first n-channel transistor (N1) and is connected between a first switching terminal (VH1) and a second switching terminal (VL1),
- with a second series circuit which is formed by a second p-channel transistor (P2) and a second n-channel transistor (N2) and is connected between the first switching terminal (VH1) and a first input terminal (E1),
- the junction point of the two transistors (P1, N1) of the first series circuit being connected to the gate terminal of the second p-channel transistor (P2) and forming an output terminal (A),
- the junction point of the transistors (P2, N2) of the second series circuit being connected to the gate terminal of the first p-channel transistor (P1), and
- the gate terminal of the second n-channel transistor (N2) forming a second input terminal (E2),
- with a third series circuit which is formed by a third p-channel transistor (P3) and a third n-channel transistor (N3) and is connected between a third input terminal (E3) and the second switching terminal (UL1),
- the junction point of the two transistors (P1, N1) of the first series circuit being connected to the gate terminal of the third n-channel transistor (N3),
- the junction point of the transistors (P3, N3) of the third series circuit being connected to the gate terminal of the first n-channel transistor (N1), and
- the gate terminal of the third p-channel transistor (P3) forming a fourth input terminal (E4), in which case
- potentials are applied firstly to the input terminals (E1, E2, E3, E4), and it is only after the application of the potentials to the input terminals (E1, E2, E3, E4) that a potential which is greater than the potentials at the input terminals is applied to the first switching terminal (VH1) or a potential which is less than the potentials at the input terminals is applied to the second switching terminal (VL1).

2. Method according to Claim 1, in which
the potentials at the switching terminals (VH1, VL1) are slowly driven up to their final value after the switch-on.

3. Method according to either of Claims 1 and 2, in which the second and the fourth input terminal (E2, E4) of the circuit arrangement are connected to one another and form a terminal for a control signal (Vin),
the first input terminal (E1) is a terminal for a second low potential (VL2) which is equal to the low operating voltage, and
the third input terminal (E3) is a terminal for a second high potential (VH2) which is equal to the high operating voltage.

4. Method according to either of Claims 1 and 2, in which
the first and the third input terminal (E1, E3) of the circuit arrangement are connected to one another and form a terminal for a control signal (Vin),
the second input terminal (E2) is a terminal for a second high potential (VH2) which is equal to the high operating voltage, and
the fourth input terminal (E4) is a terminal for a second low potential (VL2) which is equal to the low operating voltage.

5. Method according to one of Claims 1 to 4, in which
in the case of a technological realization of the transistors in a p-conducting substrate, the first and the third n-channel transistor (N1, N3) are constructed in a p-type trough which is insulated from the p-type substrate.

6. Method according to one of Claims 1 to 5, in which
in the case of a technological realization of the transistors in an n-conducting substrate, the first and the second p-channel transistor (P1, P2) are constructed in an n-type trough which is insulated from the n-type substrate.

## Revendications

1. Procédé de commutation de hautes tensions sur une puce à semi-conducteur au moyen d'un montage réalisé sur celle-ci, qui est formé
- d'un premier circuit série constitué d'un premier transistor (P1) à canal p et d'un premier transistor (N1) à canal n, qui est monté entre une première borne (VH1) de connexion et une deuxième borne (VL1) de connexion,
- d'un deuxième circuit sérié constitué d'un deuxième transistor (P2) à canal p et d'un deuxième transistor (N2) à canal n, qui est monté entre la première borne (VH1) de connexion et une première borne (E1) d'entrée,
- dans lequel le point de liaison des deux transistors (P1, N1) du premier circuit série est relié à la borne de grille du deuxième transistor (P2) à canal p et forme une borne (A) de sortie,
- dans lequel le point de liaison de liaison des transistors (P2, N2) du deuxième circuit série est relié à la borne de grille du premier transistor (P1) à canal p et
- dans lequel la borne de grille du deuxième transistor (N2) à canal n forme une deuxième borne (E2) d'entrée,
- comprenant un troisième circuit série constitué d'un troisième transistor (P3) à canal p et d'un troisième transistor (N3) à canal n qui est monté entre une troisième borne (E3) d'entrée et la deuxième borne (VL1) de connexion,
- dans lequel le point de liaison des deux transistors (P1, N1) du premier circuit série est relié à la borne de grille du troisième transistor (N3) à canal n,
- dans lequel le point de liaison des transistors (P3, N3) du troisième circuit série est relié à la borne de grille du premier transistor (N1) à canal n et
- dans lequel la borne de grille du troisième transistor (P3) à canal p forme une quatrième borne (E4) d'entrée, dans lequel
- il est appliqué d'abord aux bornes (E1, E2 E3, E4) d'entrée des potentiels et
- après l'application des potentiels aux bornes (E1, E2, E3, E4) d'entrée, il est appliqué à la première borne (VH1) de connexion un potentiel qui est plus grand que le potentiel appliqué aux bornes d'entrée ou à la deuxième borne (VL1) de connexion un potentiel qui est plus petit que les potentiels appliqués aux bomes d'entrée.

2. Procédé suivant la revendication 1, dans lequel
les potentiels appliqués aux bornes (VH1, VL1) de connexion atteignent lentement leur valeur finale après la connexion.

3. Procédé suivant la revendication 1 ou 2, dans lequel
la deuxième et la quatrième bornes (E2, E4) d'entrée du montage sont reliées entre elles et forment une borne pour un signal (Vin) de commande,
la première borne (E1) d'entrée est une borne pour un deuxième potentiel (VL2) bas, qui est égal à la tension basse de fonctionnement et
la troisième borne (E3) d'entrée est une borne pour un deuxième potentiel (VH2) haut, qui est égal à la haute tension de fonctionnement.

4. Procédé suivant Tune des revendications 1 ou 2, dans lequel
la première et la troisième bornes (E1, E3) d'entrée du montage sont reliées entre elles et forment une borne pour un signal (Vin) de commande,
la deuxième borne (E2) d'entrée est une borne pour un deuxième potentiel (VH2) haut, qui est égal à la tension haute de fonctionnement et
la quatrième borne (E4) d'entrée est une borne pour un deuxième potentiel (VL2) bas, qui est égal à la tension basse de fonctionnement.

5. Procédé suivant l'une des revendications 1 à 4, dans lequel
pour la réalisation technologique des transistors dans un substrat de conductivité p, le premier transistor (N1) à canal n et le troisième transistor (N3) à canal n sont constitués dans une cuvette de type p isolée du substrat p.

6. Procédé suivant l'une des revendications 1 à 5, dans lequel
pour la réalisation technologique des transistors dans un substrat de conductivité n, le prémier transistor (P1) à canal p et le deuxième transistor (P2) à canal p sont constitués dans une cuvette de type n isolée du substrat n.
